# EUROPÄISCHE PATENTANMELDUNG

(11) **EP 1 119 226 A2**
(43) Veröffentlichungstag der Anmeldung: **25.07.2001**
(21) Anmeldenummer: 01100572.5
(22) Anmeldetag: 10.01.2001
(51) Int. Cl.: H05K 3/20

(54) **Dünnwandige Leiterbahnen, enthaltend mindestens einen thermoplastischen Kunststoff**

(30) Priorität: 21.01.2000 DE 10002430
(71) Anmelder: Ticona GmbH, 65451 Kelsterbach (DE)
(72) Erfinder: Haack, Ulrich, 64665 Alsbach (DE); Herd, Olaf, 64839 Münster (DE); Hoffmann, Stephan, 61267 Neu-Anspach (DE); Hiekisch, Rochus, 65232 Taunusstein (DE); Radden, Peter, 65795 Hattersheim (DE)

(57) **Zusammenfassung**

Die vorliegende Erfindung betrifft dünnwandige Leiterbahnen mit einem höheren Integrationsgrad aus mindestens einem thermoplastischen Polymer, erhältlich in dem mindestens ein thermoplastisches Polymer vorplastifiziert und das Plastifikat in plastischen Zustand in ein Preßwerkzeug definiert abgelegt und anschließend in einem Preßvorgang geformt wird.

## Beschreibung

Die vorliegende Erfindung betrifft dünnwandige Leiterbahnen (Cicuit printed boards), enthaltend mindestens einen thermoplastischen Kunststoff.

Bisherige dünnwandige Leiterbahnen werden in einem aufwendigen Verfahren unter Verwendung aushärtender Harze hergestellt. Dünnwandige Leiterbahnen aus Thermoplasten konnten bisher wirtschaftlich nicht hergestellt werden. Bei den spritzgegossenen thermoplastischen Bauteilen können oft die geforderten Toleranzen, wie Planizitäten nicht erzielt werden. Das liegt auch an der starken Orientierung des verwendeten Polymers, die durch das Material selbst und durch den Anguß sowie die Angußlage vorgegeben ist.

Die Aufgabe der vorliegenden Erfindung liegt darin, dünnwandige, großflächige Leiterbahnen mit einem höheren Integrationsgrad und ein wirtschaftliches und umweltfreundliches Verfahren zu deren Herstellung bereitzustellen.

Die Aufgabe der vorliegenden Erfindung wird gelöst, dadurch, daß dünnwandige Leiterbahnen mit einem höheren Integrationsgrad aus mindestens einem thermoplastischen Polymer erhalten werden, indem mindestens ein thermoplastisches Polymer vorplastifiziert, das Plastifikat in plastischen Zustand in ein Preßwerkzeug definiert abgelegt und in einem anschließenden Preßvorgang geformt wird.

Die Erfindung bezieht sich auf die Herstellung dünnwandiger Leiterbahnen nach dem Preßverfahren.

Die Erfindung zeigt eine neue Verarbeitungsmöglichkeit unter Verwendung thermoplastischer Kunststoffe auf, die zu maßlich anspruchsvolleren Bauteilen führt. Hierbei wird das Material vorplastifiziert und das Plastifikat in noch plastischen Zustand in das Preßwerkzeug definiert abgelegt und anschließend in einem Preßvorgang geformt. Somit sind aufwendige Nacharbeiten nicht notwendig. Insbesondere wird die Herstellung selbst von komplexen Bauteilen mit entsprechenden Qualitätsmerkmalen bei günstigen Herstellkosten möglich. Ein weiterer Vorteil besteht darin, die auf Trägern unterschiedlichen Materials aufgebrachten Leiterbahnen definiert im Werkzeug einlegen zu können, und diese beim Preßvorgang weniger stark zu beanspruchen, wobei mit dem Basispolymer eine stoffschlüssige Verbindung entsteht.

Es können somit Platten, auch großflächig, kostengünstig, mit einem höheren Integrationsgrad hergestellt werden. Erfindungsgemäß sind thermoplastische Polymere wie Polyamide (PA), aromatische Polyamide (PPA), Polyethersulfide (PES), Polyetherimide(PEI), Polyurethane (PU), Polyphenylensulfide (PPS), Polyester (PBT/PET) oder Polyetherketone (PEEK, PEK) geeignet, die Füll- und/oder Verstärkungsstoffe, wie Kohlefaser oder Glasfaser enthalten können.

Gemäß der Erfindung können dünnwandige Leiterbahnen nach dem Preßverfahren hergestellt werden. Es können verzugsfreie /-arme Platten, großflächig, kostengünstig mit einem höheren Integrationsgrad hergestellt werden. Die dünnwandigen Platten weisen eine Wanddicke von 0,1 mm bis 10 mm, bevorzugt von 0,2 mm bis 2,5 mm, besonders bevorzugt von 0,3 mm bis 0,5 mm auf.

Als besonders vorteilhaft hat sich der Einsatz von thermoplastischen Kunststoffen mit einer speziellen Viskosität und Langfasern, wie Glasfasern oder Kohlefaser als Füll- und/oder Verstärkungsstoff erwiesen. Das neue Verfahren ermöglicht die spannungsfreie, verzugsarme Herstellung einer erfindungsgemäßen Platte. Dabei werden geringste Toleranzen, selbst bei größeren Wanddicken-Unterschieden im Vergleich zu spritzgegossenen Bauteilen eingehalten. Es wird somit ein höherer Integrationsgrad erreicht. Die erfindungsgemäße Leiterplatte, weist ein geringeres Gewicht und eine höhere Eigendämpfung auf. Die Herstellungskosten des erfindungsgemäßen Verfahrens sind deutlich niedriger. Eine bei herkömmlichen Verfahren zwingend erforderliche Nacharbeitung ist bei dem erfindungsgemäßen Verfahren nicht erforderlich.

## Patentansprüche

1. Dünnwandige Leiterbahnen mit einem höheren Integrationsgrad aus mindestens einem thermoplastischen Polymer, erhältlich in dem mindestens ein thermoplastisches Polymer vorplastifiziert und das Plastifikat in plastischen Zustand in ein Preßwerkzeug definiert abgelegt und anschließend in einem. Preßvorgang geformt wird.

2. Dünnwandige Leiterbahnen nach Anspruch 1, wobei das thermoplastische Polymere ein oder mehrere Polymer wie z. B. Polyamide (PA), aromatische Polyamide (PPA), Polyethersulfide (PES), Polyetherimide (PEI), Polyurethane (PU), Polyphenylensulfide (PPS), Polyester (PBT/PET) oder Polyetherketone (PEEK, PEK) enthält, die Füll- und/oder Verstärkungsstoffe, wie Kohlefaser oder Glasfaser enthalten können.

3. Dünnwandige Leiterbahnen nach Anspruch 1 oder 2, wobei die Leiterbahnen eine Wanddicke von 0,1 mm bis 10 mm aufweisen.

4. Dünnwandige Leiterbahnen nach einem oder mehreren der Ansprüche 1 bis 3, wobei die Leiterbahnen eine Wanddicke von 0,2 mm bis 2,5 mm aufweisen.

5. Dünnwandige Leiterbahnen nach einem oder mehreren der Ansprüche 1 bis 4, wobei die Leiterbahnen eine Wanddicke von 0,3 mm bis 0,5 mm aufweisen.

6. Verfahren zur Herstellung dünnwandiger Leiterbahnen mit einem höheren Integrationsgrad aus mindestens einem thermoplastischen Polymer, wobei mindestens ein thermoplastisches Polymer vorplastifiziert und das Plastifikat in plastischen Zustand in ein Preßwerkzeug definiert abgelegt und anschließend in einem Preßvorgang geformt wird.
